# EUROPEAN PATENT APPLICATION

(11) **EP 1 571 475 A1**
(43) Date of publication of application: **07.09.2005**
(21) Application number: 04425142.9
(22) Date of filing: 04.03.2004
(51) Int. Cl.: G02B 6/42, H01L 33/00

(54) **Fiber-type electro-optical diode**

(71) Applicant: C.R.F. Società Consortile per Azioni, 10043 Orbassano (Torino) (IT)
(72) Inventor: Perlo, Pietro, 10043 Orbassano (Torino) (IT); Innocenti, Gianfranco, 10043 Orbassano (Torino) (IT); Li Pira, Nello, 10043 Orbassano (Torino) (IT); Lambertini, Vito Guido, 10043 Orbassano (Torino) (IT); Repetto, Piermario, 10043 Orbassano (Torino) (IT); Brignone, Mauro, 10043 Orbassano (Torino) (IT); Paderi, Marzia, 10043 Orbassano (Torino) (IT); Monferino, Rossella, 10043 Orbassano (Torino) (IT)
(74) Representative: Quinterno, Giuseppe

(57) **Abstract**

The electro-optical diode device (1) comprises a stratified structure supported by a supporting substrate (10) and including a pair of electrodes (A, C), between which is interposed a plurality of layers (11-13; 16, 17) having specified characteristics.

The supporting substrate comprises a supporting wire (10) and the said stratified structure (11-18) has an essentially annular cylindrical shape which is substantially coaxial with the supporting wire (10).

## Description

The present invention relates to improvements to electro-optical diode devices and their applications.

In the present description, and in the following claims, the term "electro-optical diode device" generally denotes a solid-state device comprising one or more junctions, capable of generating radiation as a result of the application of a voltage (electroluminescent device), or capable of generating a voltage (photovoltaic device) or an electrical current (photodiode) as a result of its exposure to radiation.

Electroluminescent devices comprise organic thin film devices (such as the OLED type using small molecules or the PLED/Poly-LED polymer type), inorganic thin film devices (TFEL), thick film dielectric devices (TDEL), and crystalline semiconductor devices of the LED type.

In general, an electro-optical diode device includes a stratified structure carried by a supporting substrate and comprises a pair of electrodes, namely the anode and cathode, between which is interposed a plurality of layers of materials having specified characteristics.

Conventional electro-optical diode devices have a planar structure, in which the electrodes and the interposed layers are also essentially planar in form.

By way of example, an organic light-emitting diode (OLED) comprises a substrate in the form of a rigid or flexible sheet of at least partially transparent material, such as glass or PET, on which are deposited a transparent anode, consisting of indium tin oxide (ITO) or antimony tin oxide (ATO) for example, a layer of organic conductive material for the injection of holes, consisting for example of a conductive polymer such as PEDOT, an organic emitter layer consisting for example of a polymer (PPV - polyphenylvinylene) or a low molecular weight material such as AlQ3 or tris(8-hydroxyquinoline)aluminium, a layer of organic material for the electron transport, and finally a metallic layer, of aluminium for example, acting as a cathode.

When an appropriate voltage, typically consisting of a few volts, is applied to such a "sandwich" formed between the cathode and the transparent anode, the injected positive and negative charges are recombined in the emitter layer to produce light (electroluminescence). The light radiation emerges through the supporting substrate, which typically consists of glass or a polymer material such as PET (polyethylene terephthalate).

A conventional light-emitting diode typically comprises a forward-biased p-n junction. During operation, minority charge carriers are injected at the junction: the electrons migrate from the n zone to the p zone, and the holes migrate in the opposite direction. The recombination of these charge carriers takes place in the depletion layer. The electrons then fall from the level occupied in the conduction band to an empty level in the valence band, emitting a quantity of energy in the form of photons, corresponding to the energy difference or gap between the two levels. Gallium arsenide (GaAs) LEDs emit infrared radiation, since the said energy gap is 1.43 EV. Mixed GaAs and GaP LEDs, which may also include other metals (for example AlInGaP), emit radiation in the red range, since in their case the energy gap is greater. Finally, silicon carbide (SiC) or gallium nitride (GaN) diodes emit radiation in the blue range.

Inorganic film electroluminescent devices generally comprise a plurality of layers of conducting, insulating and electroluminescent inorganic material. The standard architecture of an inorganic electro-optical device comprises a stratified structure supported by a rigid or flexible support, comprising a conducting layer used as an electrode, a layer of insulation, a layer of electroluminescent inorganic material, generally a semiconductor, another insulating layer and a second conducting layer acting as the second electrode.

Standard inorganic electro-optical devices consist of stratified structures of thin films (TFEL - Thin Film Electro-Luminescent devices) or thick films (TDEL - Thick Dielectric Electro-Luminescent devices).

For example, a TFEL device consists of what is known as an MISIM (Metal Insulator Semiconductor Insulator Metal) structure; in particular, the first layer of metal is generally Al or another conductor, the semiconductor layer comprises, for example, Y₂O₂S:Eu, ZnS:Cu,Au,Al, and ZnS:Ag,Cl or other electroluminescent semiconductors, and the second layer of metal can comprise doped ZnO or conductive oxides such as ITO, ATO or conductors which permit light transmission. The layer of insulation can comprise oxides in general (Al₂O₃, Si₃N₄, TiO₂, BaTa₂O₆, etc.). The various layers are produced mainly by high-vacuum deposition methods (E-beam evaporation, thermal deposition or sputtering).

The architecture of a TDEL device is similar to that of a TFEL device, except for the fact that one of the two insulating layers is replaced with a thick dielectric film. The layers are thicker and are mainly produced by low-cost deposition methods such as screen printing or the like, or combinations of screen printing and high-vacuum deposition (E-beam evaporation, thermal deposition or sputtering), or by immersion or dipping.

The operation of inorganic electro-optical devices, whether of the TFEL or TDEL type, is essentially based on the phenomenon of field emission or electronic tunnelling: the charges extracted from the conductor pass through the potential barrier formed by the insulating layer and are recombined within the semiconductor with the holes created in the opposite direction, producing radiation. This extraction is caused by the large electrical field applied to the structure. The emitted current, known as the tunnelling current, is defined by the relation which expresses the current density for a Schottky barrier.

An object of the present invention is to propose electro-optical diode devices having an innovative structure permitting the development of a new range of original applications in the field of lighting, in the field of display, and in other fields.

These and other objects are achieved according to the invention with an electro-optical diode device of the type specified above, characterized in that its supporting substrate comprises a supporting wire, and the aforesaid stratified structure is positioned around the said supporting wire and has an essentially annular cylindrical shape which is substantially coaxial with the said supporting wire.

The supporting wire can be substantially rigid or flexible. This supporting wire can also consist of an electrically conductive material, or of an electrically insulating material, and in particular a material transparent to the emitted radiation (optical fibre).

As described more fully below, the supporting wire, when consisting of an electrically conductive material, can form the central electrode (cathode or anode) of the electro-optical device.

The stratified structure supported by the supporting wire can be suitable for forming an LED, an OLED/PLED, a TFEL or TDEL, or a photodiode, or more generally any semiconductor heterostructure.

Further characteristics and advantages of the invention will be made clear by the following detailed description, provided here purely by way of example and without restrictive intent, with reference to the attached drawings, in which:
Figure 1 is a partial perspective view which shows a longitudinal portion of an electro-optical diode device constructed according to the present invention;
Figures 2 and 3 are partial perspective views which show variant embodiments of electro-optical diode devices according to the invention;
Figure 4 is a view in axial section of another electro-optical device according to the invention;
Figures 5 to 9 are partial perspective views which show further variant embodiments;
Figure 10 is a view in axial section of an electro-optical device according to the invention;
Figure 11 is another partial view in axial section which shows, above and below the longitudinal axis, two variant embodiments of electro-optical diode devices according to the invention;
Figure 12 is a schematic representation which shows a piece of equipment comprising two electro-optical diode devices according to the invention and an electrical energy accumulator interposed between them; and
Figure 13 is a schematic representation of an optical fibre amplifier comprising electro-optical devices according to the invention.

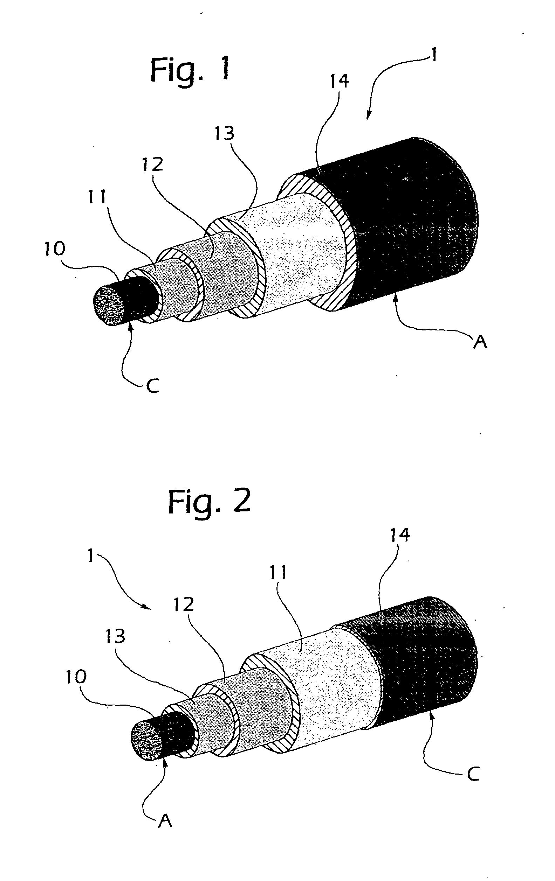

In Figure 1, the number 1 indicates the whole of a first electro-optical diode device constructed according to the present invention. This device is, in particular, an OLED or a PLED, and comprises a supporting wire 10 covered with a series of layers deposited one on top of another.

In the example of embodiment shown in Figure 1, the supporting wire 10 is an electrically conductive wire, such as a metal wire. In general, the term "supporting wire" can also denote a multi-filament cable or a cord formed from a plurality of interwoven filaments or trefoils.

On the supporting wire 10, which in the embodiment shown in Figure 1 conveniently acts as a cathode, there is placed a coaxial annular layer of organic electron carrier material 11, and on this there is deposited a layer of organic emitter material 12, consisting for example of a polymer or a low molecular weight compound. On the organic emitter layer 12 there is deposited a layer 13 of organic material for the injection of holes, on which there is deposited a layer 14 of radiation-transparent material acting as an anode, consisting of ITO for example. In operation, this anode allows the radiation generated in the emitter layer 12 to pass radially to the outside.

In Figure 1, the supporting wire 10 and the outermost layer 14 have also been identified with the letters C and A respectively, to indicate that they act as the cathode and anode respectively.

Figure 2 shows a variant embodiment. In this figure, parts and elements identical or substantially equivalent to those described previously have been given the same reference symbols.

In the variant shown in Figure 2, the electro-optical device of Figure 1 comprises an electrically conductive supporting wire 10, for example a metal wire, which acts as an anode during operation. The supporting wire 10 in Figure 2 has therefore also been identified with the letter A. On this anode there are deposited, in the following sequence, a first annular layer 13 of organic material for the injection of holes, an organic emitter layer 12, an organic electron carrier layer 11, and an external conductive layer 14 which in this case acts as a cathode C. The layer 14 acting as a cathode conveniently consists of a very thin metal layer, continuous or percolated, such that it can still sustain a flow of electrical current, but is at least partially transparent to the radiation generated by the operation of the electro-optical device.

The layer 14 can be protected if necessary by a further transparent layer of polymer or glass, which acts as a barrier to the penetration of oxygen and water vapour.

In a way which is not shown in Figure 2, it is possible to apply to the cathode 14 (C) a small metal element which is sufficient to provide a good contact with conductors for connection to power supply and/or control circuits but does not cause significant reflection of the outgoing radiation.

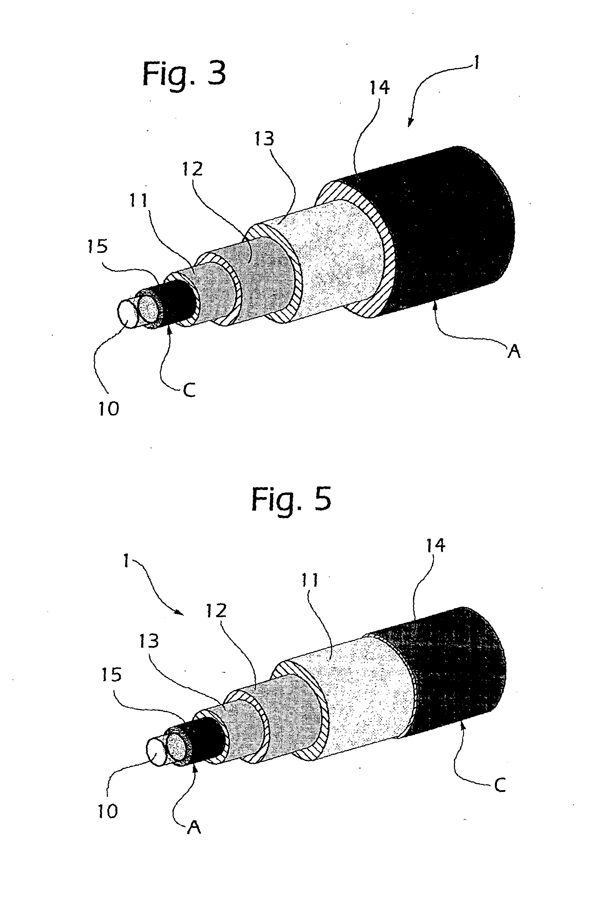

Figure 3 shows a further embodiment of the device described above with reference to Figure 1. In Figure 3, the same reference symbols have again been allocated to parts and elements described previously.

In the embodiment according to Figure 3, the electro-optical device 1 comprises a supporting wire 10 of electrically insulating material (dielectric). This material can generally be rigid or flexible. The wire 10 can be, for example, a textile wire, or a single-mode or multimode optical fibre.

On the supporting wire 10 there is deposited a first layer 15 of electrically conductive material, particularly a metallic material, acting in operation as a cathode (C). On top of the layer 15 there are deposited layers 11-14 corresponding to those described previously with reference to Figure 1. Thus the outermost layer 14 acts as an anode (A) in the electro-optical device according to Figure 3 as well, and is, in particular, transparent to the generated radiation.

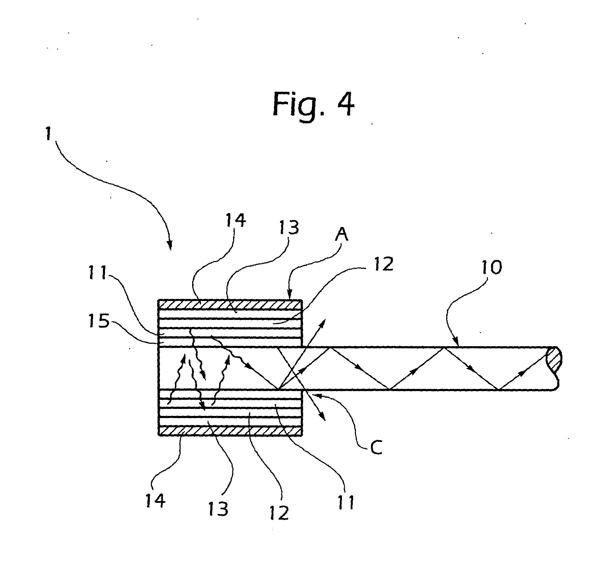

In a variant embodiment shown in Figure 4, the external electrode 14 (anode A) reflects the generated radiation, and the internal electrode 15 (cathode C) is at least partially transparent and is deposited on a supporting wire 10 (optical fibre) which is transparent to the emitted radiation. In this embodiment, during operation the radiation generated can be propagated along the supporting wire 10, and the surface of this wire or optical fibre 10 can be structured (with a diffraction grating for example) to facilitate the injection of radiation into the fibre. The electro-optical device 1, when suitably driven with a continuous or pulsed voltage, can then act as a generator of optical signals which are propagated in the supporting wire 10 towards optical circuitry connected to it. In this configuration, the emitting electro-optical device typically extends over a portion of reduced length of an optical fibre: the radiation emitted by the junction is injected into the said portion and is then propagated within the fibre.

The reduced length of the emitter device allows some of the radiation injected into the fibre 10 to fall directly on a portion of fibre which is substantially "bare", in other words free of the external stratified structure; reflection in this "bare" portion takes place by total internal reflection (TIR) and therefore with negligible losses, allowing the propagation of the signal to continue. On the other hand, the radiation injected into the fibre which again falls on the portion of fibre covered by the stratified structure is subject to losses due to the non-negligible absorption of the said structure. In any case, the portion of radiation propagated at angles smaller than the TIR angle escapes from the bare portion of the fibre 10, thus interrupting its propagation. Figure 4 shows by way of example an electro-optical device 1 with an annular configuration which covers a portion of reduced length of the optical fibre 10.

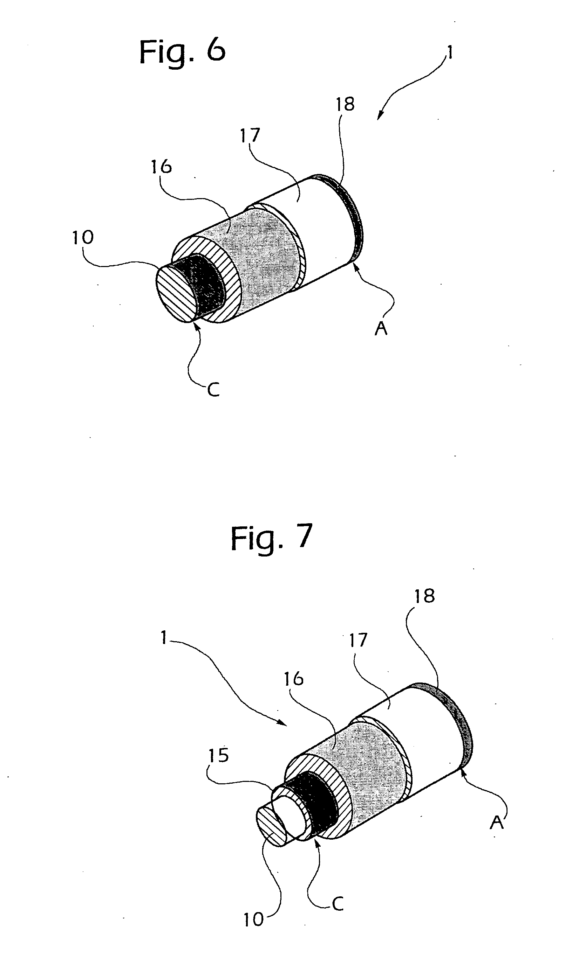

Figure 5 shows a further variant embodiment, similar in some ways to that of Figure 3.

In the variant shown in Figure 5, the supporting wire 10 is made from electrically insulating material (dielectric) and can be, in particular, an optical fibre. On this supporting wire 10 there is deposited a first layer 15 of electrically conductive material, acting in operation as an anode (A). Further layers 13, 12, 11 and 14 are deposited in succession on top of the anode 15 as in the variant shown in Figure 2. The outermost conductive layer 14 acts in operation as a cathode C, and can be continuous or percolated, and nonhomogeneous if necessary, and can be thin enough to be substantially transparent to the generated radiation.

In a variant which is not shown, but which has essentially the same structure as that shown in Figure 5, the internal electrode 15 acting as the anode A is at least partially transparent to the generated radiation, and is deposited on a supporting wire 10 which is transparent to the emitted radiation (optical fibre). Additionally, the external electrode 14, acting as the cathode C, is reflective with respect to the radiation. In this variant, the generated radiation can be propagated along the optical fibre 10 acting as the supporting wire for the electro-optical device, in a way similar to that described in relation to Figures 3 and 4.

Figures 6 and 7 show two electro-optical devices 1 whose stratified structure is such that it forms a crystalline inorganic semiconductor LED.

The LED 1 of Figure 6 comprises a supporting wire 10, of electrically conductive material, acting in operation as a cathode. A coaxial cylindrical annular layer 16 of semiconductor material, for example Gan, InGan, AlInGaP, etc., with n-type doping, is deposited on the conductive supporting wire 10. On this layer there is deposited a further layer 17 of semiconductor material, of a type similar to that of the layer 16, but with p-type doping. An outermost electrically conductive layer 18, acting in operation as an anode (A), is deposited on the layer 17.

A layer of crystalline intrinsic semiconductor, allowing the epitaxial growth of the crystalline layers forming the junction, can be deposited between the supporting wire 10 and the n-type layer 16. The said intrinsic semiconductor can be the same material as that used for the p and/or n layer, or a different material which is crystallographically compatible with the layers forming the junction.

In operation, when a forward biasing voltage is applied between the anode and cathode, the recombination of the electrons and holes in the depletion layer of the p-n junction causes energy to be emitted in the form of radiation.

The external electrode 18 acting as the anode A can be made with apertures to allow the exit of the radiation, or can be made thin enough to be at least partially transparent to the generated radiation.

In an advantageous configuration, the thicknesses between the active layers are such that a microcavity resonant at the emission wavelength is formed.

In a variant embodiment which is not shown, the inorganic LED device according to the invention consists of a multilevel heterostructure, at levels positioned according to layers deposited on a cylindrical substrate.

In a further variant which is not shown, the supporting wire 10 of electrically conductive material acts as the anode, and the outermost conductive layer acts in operation as the cathode.

In the variant shown in Figure 7, the same reference symbols are given to parts and elements described previously.

In the embodiment shown in Figure 7, the supporting wire 10 of the electro-optical diode device 1 is made from electrically insulating material (dielectric), such as an optical fibre. An electrically conductive layer 15, which may for example be metallic, is deposited on this wire and acts in operation as the cathode C. The layers 16, 17 and 18 are then deposited on the internal electrode 15, as in the device shown in Figure 6.

In a variant which is not shown, the internal electrode of the electro-optical device 1 shown in Figure 7 is at least partially transparent to the generated radiation, and the supporting wire 10 of dielectric material is optically transparent (optical fibre). In this case, the generated radiation is propagated along the supporting wire 10.

In variant embodiments which are not shown, but are structurally similar to those shown in Figures 6 and 7, electro-optical diode devices according to the invention can act as photodiodes or as photovoltaic converters.

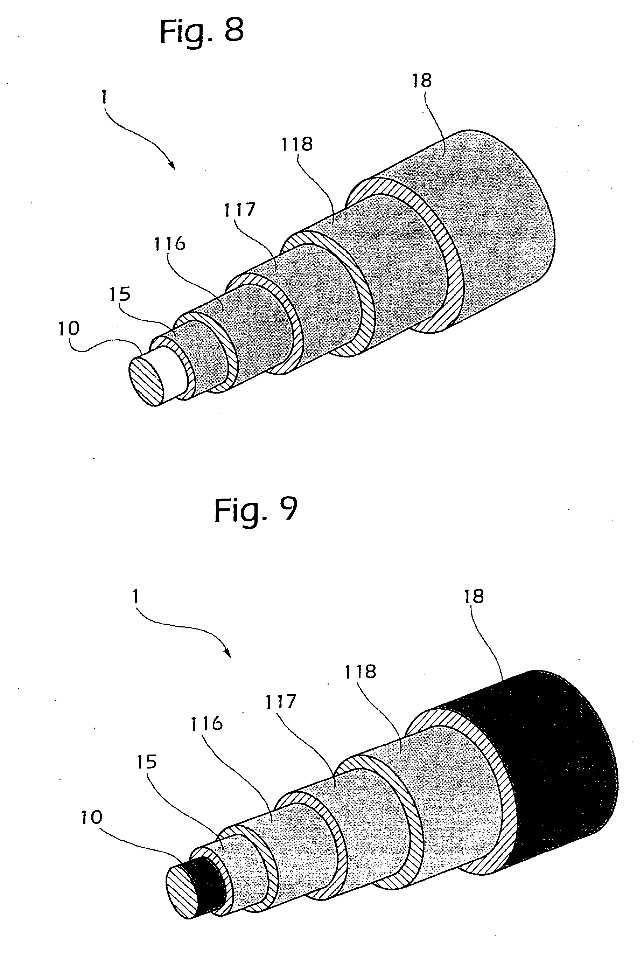

Figures 8 and 9 are schematic illustrations of inorganic electro-optical devices according to the invention, of the TFEL or TDEL type.

The device 1 of Figure 8 comprises an optically transparent supporting wire 10 (optical fibre) on which are deposited in succession a transparent conductive layer 15 acting as an electrode, an insulating layer 116, a layer of luminescent semiconductor material 117, a further insulating layer 118 and an external conductive layer 18 acting as an electrode. The considerations expressed previously in relation to Figures 3 and 4 are applicable, mutatis mutandis, to the electro-optical device 1 of Figure 8.

The device 1 of Figure 9 has a structure similar to that of the device shown in Figure 8, formed on a non-transparent supporting wire 10. The layer 15 acting as an internal electrode is also non-transparent, while the external electrode 18 is at least partially transparent.

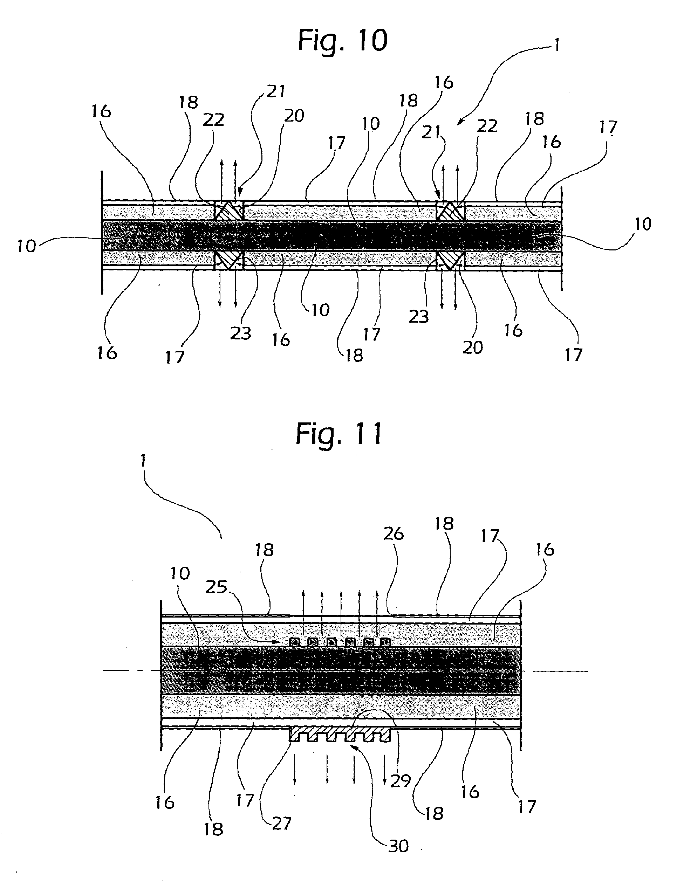

Figures 10 and 11 are schematic and partial illustrations of electro-optical diode devices according to the invention in which the outermost electrode is substantially reflective with respect to the radiation generated in operation. These electro-optical devices incorporate optical devices allowing the emitted radiation to be extracted in the outward radial direction.

Figure 10 is a schematic representation of the structure of an electro-optical LED device, whose structure is essentially of the type described with reference to Figure 6.

The stratified structure 16-18 of the electro-optical device 1 of Figure 10 has a plurality of breaks 20, in each of which is positioned an annular reflector device 21 for diverting the generated radiation in an outward radial direction. In the illustrated embodiment, each reflector device 21 comprises an annular prism 22 with a triangular section, with the apical circumference facing outwards, having a first refractive index n₁, incorporated in an at least partially transparent ring 23, having a second refractive index n₂.

Figure 11 shows two different solutions for enabling the radiation to be extracted in an electro-optical device 1. In the solution shown in the upper part of Figure 11, a corrugation 25, capable of substantially diffusing the incident radiation radially outwards, is formed at the interface between the internal electrode (cathode or anode 10) and the innermost semiconductor layer 16. This corrugation 25 extends along the internal electrode 10 at the position of a discontinuity or aperture 26 of the external electrode 18, through which the radiation can emerge radially.

The lower part of Figure 11 shows a variant embodiment in which a transparent element 29, provided with a corrugation 30 capable of substantially diffusing the generated radiation radially outwards, is positioned in a discontinuity or aperture 27 of the external electrode 18.

The scope of the present invention also includes any radiation emitting apparatus comprising a plurality of electro-optical emitters of the types described above.

The scope of the invention also includes any radiation emitting apparatus which comprises at least one photoemitter device of one of the types described above, and at least one photodiode device as described above, used as an electrical generator for a power supply.

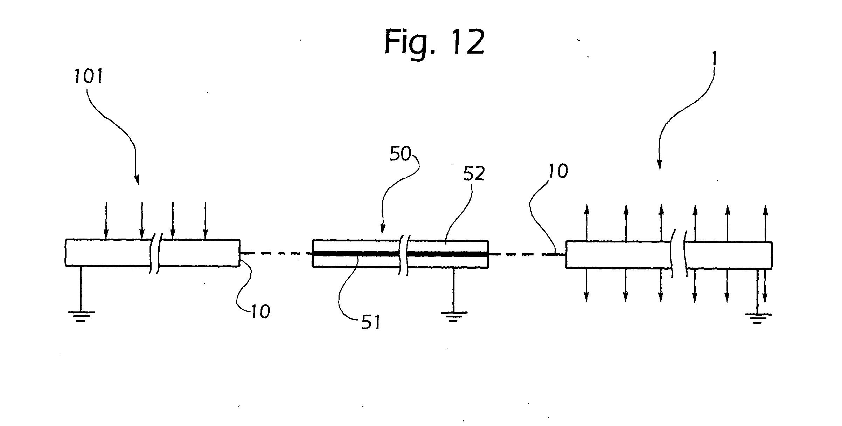

Figure 12 shows, by way of example and schematically, an arrangement in which a photoemitter device 1 according to the invention is coupled to a photodiode 101 according to the invention acting as an electrical generator, with the interposition of an electrical energy accumulator device 50. This accumulator device can comprise, for example, a capacitor, with an inner plate 51, in the form of a rigid or flexible wire for example, and an associated coaxial outer plate 52, with the interposition of a dielectric. This coaxial cylindrical configuration of the accumulator enables it to be integrated with the photodiode 101 or with the photoemitter device 1 if required.

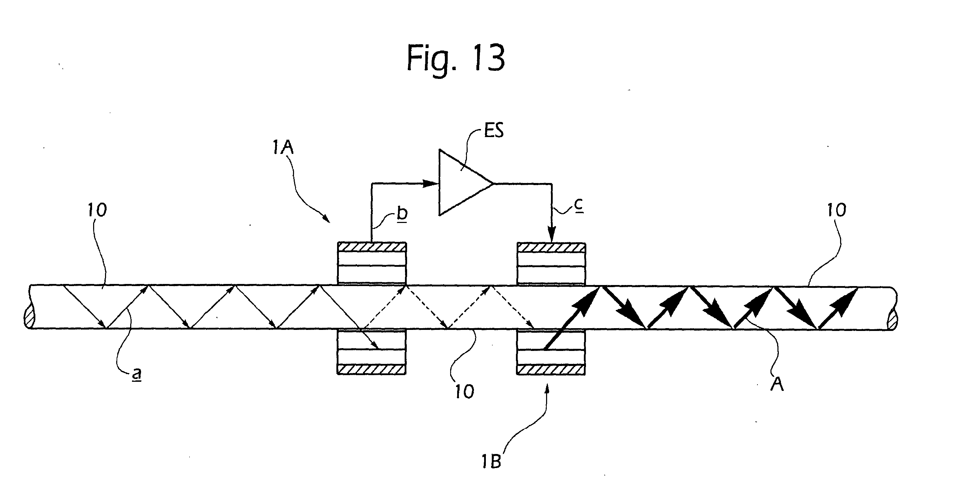

Figure 13 shows, in a schematic and simplified way, a solution which, on an optical fibre 10, uses a device 1A according to the invention, acting as a means of detecting an optical signal a emitted by a remote emitter and propagated along the fibre 10, and another device 1B according to the invention, acting as a means of emission. These devices 1A and 1B are connected electrically to an electronic system ES capable of amplifying the detected signal b obtained by the conversion of the corresponding optical signal a, and of supplying the amplified electronic signal c to the emitter device 1B to cause an amplified optical signal A to be propagated in the fibre.

Electro-optical diode devices according to the invention can be made in the form of flexible wire-like emitters, having dimensions so small that they can be interwoven to form an illuminable textile, having entirely distinctive aesthetic effects.

Clearly, provided that the principle of the invention is retained, the forms of embodiment and the details of construction can be varied widely from what has been described and illustrated purely by way of example and without restrictive intent, without departure from the scope of the invention as defined in the attached claims.

## Claims

1. Electro-optical diode device (1) comprising a stratified structure supported by a supporting substrate (10) and including a pair of electrodes (A, C), between which is interposed a plurality of layers (11-13; 16, 17) having specified characteristics;
the electro-optical diode device being **characterized in that** the supporting substrate comprises a supporting wire (10) and
the said stratified structure (11-18) has an essentially annular cylindrical shape which is substantially coaxial with the supporting wire (10).

2. Device according to Claim 1, in which the supporting wire (10) is substantially rigid.

3. Device according to Claim 1, in which the supporting wire (10) is flexible.

4. Device according to any one of the preceding claims, in which the supporting wire (10) is electrically conductive.

5. Device according to any one of Claims 1 to 3, in which the supporting wire (10) is electrically insulating.

6. Device according to Claim 5, in which the supporting wire (10) is transparent.

7. Device according to Claim 4, in which the supporting wire (10) forms the cathode (C) or the anode (A).

8. Device according to Claim 5 or 6, in which the cathode or the anode (15; C, A) is placed on the electrically insulating supporting wire (10).

9. Device according to any one of the preceding claims, in which the said stratified structure (10-18) is suitable for forming a LED, particularly an inorganic semiconductor LED, an OLED or a PLED.

10. Device according to any one of the preceding claims, in which the said stratified structure (10-18) is suitable for forming a TFEL or a TDEL.

11. Device according to Claims 4, 7 and 9, comprising a cathode (C) formed by the electrically conductive supporting wire (10), and an external anode (A, 18) transparent to the radiation generated during operation.

12. Device according to Claims 4, 7 and 9, comprising an anode (A) formed by the electrically conductive supporting wire (10), and an external cathode (C), particularly a metallic cathode, transparent to the radiation generated during operation.

13. Device according to Claims 5, 8 and 9, comprising a cathode (15, C) placed on the electrically insulating supporting wire (10), and an external anode (14, A) transparent to the radiation generated during operation.

14. Device according to Claims 5, 8 and 9, comprising an anode (15, A) placed on the electrically insulating supporting wire (10), and an external cathode (14, C), particularly a metallic cathode, transparent to the radiation generated during operation.

15. Device according to any one of Claims 1 to 9, in which the outermost layer (18) of the said stratified structure is substantially reflective with respect to the radiation generated during operation, and in which the said stratified structure has at least one interruption (20) in which are placed reflector means (21) capable of diverting the said radiation radially outwards.

16. Device according to Claim 15, in which the said reflector means comprise an annular prism (22) of a material having a first refractive index (n₁), incorporated in an at least partially transparent ring (23) having a second refractive index (n₂).

17. Device according to Claim 15, in which the said reflector means consist of an annular prism (22) incorporated in the active stratified structure.

18. Device according to any one of Claims 1 to 9, in which the external electrode (18) is substantially reflective with respect to the radiation generated during operation, and in which a corrugation (25), capable of diffusing the said radiation outwards in a substantially radial direction, is formed at the interface between the internal electrode (10), whether cathode or anode, and the innermost layer (16) of the said structure; the said corrugation (25) extending along the internal electrode (10) at the position of a discontinuity or aperture (26) of the external electrode (18).

19. Device according to any one of Claims 1 to 9, in which the external electrode (18) is substantially reflective with respect to the radiation generated during operation, and has at least one discontinuity (27) at the position of which there is placed an element (29) transparent to the said radiation and having a surface microstructure (30) capable of diffusing the said radiation outwards in a substantially radial direction.

20. Device according to Claims 6 and 8, in which the external electrode (14) is reflective with respect to the radiation generated during operation, and the internal electrode (15) is transparent to the said radiation, in such a way that this radiation can be propagated in the supporting wire (10) which is transparent to the radiation.

21. Device according to Claim 20, in which the said supporting wire (10) is an optical fibre and the stratified structure is placed only along a portion of the said fibre (10) whose length is much less than the length of the said fibre (10).

22. Device according to Claim 20 or 21, designed to act as an emitter of visible or infrared radiation.

23. Device according to Claim 20 or 21, designed to act as a detector of visible or infrared radiation.

24. In-fibre optical amplifier device, comprising at least one detector device (1A) according to Claim 23 and at least one emitter device (1B) according to Claim 22, the said detector device (1A) being capable of detecting an optical signal (a) emitted by a remote emitter and propagated along the fibre (10), and of converting the said optical signal (a) into a corresponding electrical signal (b), electronic processing means (ES) being provided to amplify the said electrical signal (b) and to supply the amplified electrical signal (c) to the emitter device (1B), thus stimulating the emission of an amplified optical signal (A) towards the fibre (10).

25. Device according to any one of Claims 1 to 8, in which the said stratified structure (10, 15-18) is suitable for forming a photodiode.

26. Radiation emitter equipment comprising at least one emitter device (1) according to any one or more of Claims 1 to 20, and at least one photodiode device (101) according to Claim (19) used as a photovoltaic generator for supplying the said at least one emitter device (1).

27. Equipment according to Claim 26, additionally comprising an electrical energy accumulator device (50) for storing energy generated by the photodiode device (101).

28. Equipment according to Claim 27, in which the accumulator (50) comprises a capacitor including an inner plate (51), essentially in the form of a wire, and an associated coaxial outer plate (52).

29. Lighting equipment comprising one or more radiation emitter devices (1) according to any one or more of Claims 1 to 20.

30. Textile comprising an interwoven plurality of flexible wire-like emitter devices (1) according to any one or more of Claims to 20.
